(19) **Europäisches Patentamt**

**European Patent Office**

**Office européen des brevets**

(11) Veröffentlichungsnummer: **0 277 483 B1**

(12) # EUROPÄISCHE PATENTSCHRIFT

(45) Veröffentlichungstag der Patentschrift: **20.05.92**

(21) Anmeldenummer: **88100140.8**

(22) Anmeldetag: **08.01.88**

Die Akte enthält technische Angaben, die nach dem Eingang der Anmeldung eingereicht wurden und die nicht in dieser Patentschrift enthalten sind.

(51) Int. Cl.⁵: **C08G 18/65**, C08G 18/34, C08G 18/79, C09D 5/04

(54) **Verfahren zur Herstellung eines Thixotropiermittels, insbesondere für lagerstabile Polyurethan-Reaktivsysteme.**

(30) Priorität: **20.01.87 DE 3701409**

(43) Veröffentlichungstag der Anmeldung: **10.08.88 Patentblatt 88/32**

(45) Bekanntmachung des Hinweises auf die Patenterteilung: **20.05.92 Patentblatt 92/21**

(84) Benannte Vertragsstaaten: **BE DE FR GB IT NL**

(56) Entgegenhaltungen: **US-A- 3 183 109 US-A- 4 403 085 US-A- 4 496 684**

(73) Patentinhaber: **BAYER AG**

**W-5090 Leverkusen 1 Bayerwerk(DE)**

(72) Erfinder: **Hess, Heinrich, Dr. Körnerstrasse 5 W-5090 Leverkusen 1(DE)**
Erfinder: **Grögler, Gerhard, Dr. V.-Diergard-Strasse 48 W-5090 Leverkusen 1(DE)**
Erfinder: **Kopp, Richard, Dr. Bilharzstrasse 15 W-5000 Köln 80(DE)**

**Beschreibung**

Die vorliegende Erfindung betrifft ein Verfahren zur Herstellung von thixotropierten Polyolen, insbesondere für reaktive Polyurethansysteme, indem man insbesondere Uretdiongruppen enthaltende Polyisocyanate, vorzugsweise in Gegenwart von höhermolekularen Polyetherpolyolen mit polyfunktionellen Carbonsäuren, die mindestens eine Carboxylgruppe und gegebenenfalls OH-Gruppen enthalten, reagieren läßt. Diese Umsetzungsprodukte, vorzugsweise in Polyetherpolyolen, eignen sich insbesondere als Thixotropiermittel bei der Herstellung von Beschichtungsmassen und Klebstoffen aus lagerstabilen Polyurethan-Reaktivsystemen, den sogenannten Einkomponentensystemen.

Es ist bekannt, daß Beschichtungs- und Klebstoffmassen, die an nicht waagerechten Oberflächen aufgebracht werden sollen, bestimmte rheologische Eigenschaften aufweisen müssen, um ein Ablaufen während des Verfestigens zu verhindern. Zu diesem Zweck werden verschiedene Hilfsmittel zur Thixotropierung zugesetzt, die nicht nur das Ablaufen sondern auch das Sedimentieren von Füllstoffen, Pigmenten oder anderen festen Teilchen wie z.B. feinverteilten festen Reaktionspartnern, verhindern sollen. So sind als anorganische Thixotropier- und Verdickungsmittel unter anderen feinverteilte pyrogene, (modifizierte) Kieselsäure, modifizierte Schichtsilikate (= Smekdite) und als organische Thixotropier- und Verdickungsmittel u.a. Rizinusölderivat bekannt.

Bei der Herstellung von Beschichtungs- oder Klebstoffmassen auf Basis von Polyurethanen, die auf nicht waagerechten Oberflächen verteilt werden sollen, hat man auch bereits als Thixotropiermittel feinverteilte Polyharnstoffe aus aliphatischen oder aromatischen Polyaminen und aliphatischen oder aromatischen Polyisocyanaten eingesetzt. Diese Polyharnstoffe können entweder der Polyol- oder der Polyisocyanatkomponente zugesetzt werden. Sie bewirken dann bereits vor Applizierung eine wirksame Verdickung der entsprechenden Komponente. Wenn dies aus anwendungstechnischen Gründen unerwünscht ist, kann die Thixotropierung auch erst bei der Applizierung, d.h. im Mischkopf oder auf dem Weg in die Form oder direkt auf der zu beschichtenden Oberfläche stattfinden, indem man zunächst z.B. der Polyolkomponente nur Polyamin zusetzt und anschließend durch Zugabe der entsprechenden Isocyanatkomponente rasch die Thixotropierung unter Bildung von Polyharnstoff herbeiführt.

Auch bei den bekannten (vgl. DE-OS 32 30 757 oder DE-OS 31 12 054) hitzehärtbaren lagerstabilen PU-Reaktivsystemen, den sogenannten Einkomponentensystemen, die u.a. durch Wärmezufuhr zu Polyurethan ausgehärtet werden können, kann es notwendig sein, eine Thixotropierung der reaktiven Mischungen herbeizuführen, um nicht nur ein Ablaufen der applizierten Beschichtungs- oder Klebstoffmassen zu verhindern, sondern auch während der Lagerung eine Sedimentation der suspendierten festen Bestandteile zu verhindern.

Mit den bekannten Thixotropiermitteln gelingt dies nicht in befriedigender Weise, da die Wirkung der Thixotropiermittel in üblichen Mengen in aller Regel zu schwach ist. Wenn aber durch Erhöhung der zugesetzten Menge die gewünschte Wirkung erzielt wird, zeigt das ausreagierte Polyurethan einerseits Störungen, wie Verminderung der Festigkeit bei Verwendung anorganischer Thixotropiermittel oder andererseits Fehlstellen durch Blasenbildung oder Verminderung der Klebstoffwirkung bei der Zugabe von organischen Thixotropiermitteln, wie Polyharnstoffen. Polyharnstoffe haben außerdem den Nachteil, daß bei einer Langzeitlagerung nicht die gewünschte Sedimentationsstabilisierung bewirkt wird.

Es bestand daher ein Bedarf, ein geeignetes Thixotropier- und Verdickungsmittel für insbesondere hitzehärtbare, lagerstabile PU-Reaktivsysteme, sog. Einkomponenten-PU-Systeme, zur Verfügung zu stellen, welches die bekannten Nachteile nicht aufweist.

Gegenstand der vorliegenden Erfindung ist ein Verfahren zur Herstellung thixotropierter höhermolekularer Polyole, mit sekundären OH-Gruppen und einem Molekulargewicht von 400 - 10000, das dadurch gekennzeichnet ist, daß man dem Polyol 0,01 - 10 Gew.-% (bezogen auf das Polyol) einer polyfunktionellen aliphatischen $C_2$ - $C_{10}$ -Carbonsäure mit mindestens einer Carboxylgruppe und gegebenenfalls OH-Gruppen und eine mindestens äquivalente Menge, bezogen auf Carbonsäure, an Uretdionpolyisocyanaten zugesetzt und die Carbonsäure und das Isocyanat in dem Polyol umsetzt.

Als Uretdionpolyisocyanate sind Diisocyanate bevorzugt.

Die Carbonsäure soll vorzugsweise 2 bis 4 Carboxylgruppen aufweisen und ferner 0 bis 6 OH-Gruppen aufweisen.

Insbesondere kommen für das erfindungsgemäße Verfahren folgende Polycarbonsäuren oder Hydroxycarbonsäuren in Frage: Milchsäure, Ricinolsäure, Äpfelsäure, Weinsäure, Zitronensäure, Dimethylolpropionsäure, Adipinsäure, Besonders bevorzugt wird Äpfelsäure, Weinsäure, Zitronensäure, Dimethylolpropionsäure und Adipinsäure eingesetzt.

Die Uretdiongruppen enthaltenden Polyisocyanate sind aus dem Stande der Technik, insbesondere der DE-OS 32 30 757 oder DE-OS 31 12 054 bekannt. Bevorzugt werden dimeres Hexamethylendiisocyanat, dimeres Isophorondiisocyanat, dimeres Diphenylmethandiisocyanat oder dimeres Toluylendiisocyanat eingesetzt. Besonders bevorzugt wird dimeres Toluylendiisocyanat für das erfindungsgemäße Verfahren verwendet.

Zur Durchführung des erfindungsgemäßen Verfahrens werden vorzugsweise die (Hydroxy-) Carbonsäuren in einem höhermolekularen Polyol, vorzugsweise einem Polyetherpolyol, gelöst, und die Uretdionringe enthaltende Polyisocyanate, vorzugsweise Diisocyanate, in flüssiger, vorzugsweise in gelöster, Form zugegeben oder in fester Form feinverteilt suspendiert. Durch Erhitzen auf Temperaturen von 90 bis 150°C, vorzugsweise 100 bis 120°C und gegebenenfalls unter Mitverwendung von aus der PUR-Chemie bekannten Katalysatoren wird das Thixotropiermittel, vorzugsweise ein dadurch bereits thixotropiertes Polyol, insbesondere ein thixotropiertes Polyetherpolyol, mit ausreichender Reaktionsgeschwindigkeit hergestellt.

Den höhermolekularen Polyolen werden bevorzugt 0,1 bis 5 Gew.-%, der polyfunktionellen Carbonsäure und mindestens äquivalente Mengen, bezogen auf Carbonsäure, an Uretdionpolyisocyanaten zugesetzt. Zur Beschleunigung der Umsetzung können der reaktiven Mischung noch die üblichen, in der Polyurethanchemie bekannten Katalysatoren zugesezt werden, wie z.B. tertiäre Amine und metallorganische Verbindungen, vorzugsweise Triethylamin, Tributylamin, Diazabicyclo-2,2,2-octan und metallorganische Zinn-oder Bleiverbindungen.

Als reaktives Reaktionsmedium bei der Herstellung der erfindungsgemäßen Thixotropiermittel, das außerdem dabei auch gleichzeitig thixotropiert werden kann, kommen die in der Polyurethanchemie bekannten höhermolekularen Polyole, insbesondere Polyole mit 2 bis 8 Hydroxylgruppen, vorzugsweise mit 2 bis 4 Hydroxylgruppen und Molekulargewichten von 400 bis 10 000 wie z.B. Hydroxylgruppen aufweisende Polyester, Polyether, Polythioether, Polyacetale, Polycarbonate und Polyesteramide, in Frage. Besonders geeignet sind mindestens 2, in der Regel 2 bis 8, vorzugsweise 2 bis 3, Hydroxylgruppen aufweisende Polyether, wie sie z.B. durch Polymerisation von Epoxiden wie Ethylenoxid, Propylenoxid, Butylenoxid, Tetrahydrofuran, Styroloxid oder Epichlorhydrin mit sich selbst, z.B. in Gegenwart von Lewiskatalysatoren oder durch Anlagerung dieser Epoxide, vorzugsweise von Ethylenoxid und Propylenoxid, gegebenenfalls im Gemisch oder nacheinander an Startkomponenten mit reaktionsfähigen Wasserstoffenatomen wie Wasser, Alkohol, Ammoniak oder Amine, z.B. Ethylenglykol, Propylenglykol-(1,3) oder -(1,2), Trimethylolpropan, Glycerin, Sorbit, 4,4'-Dihydroxydiphenylpropan, Anilin, Ethanolamin oder Ethylendiamin, hergestellt werden. Auch Sucrose-Polyether, wie sie z.B. in der DE-AS 11 76 358 und 10 64 938 beschrieben werden, sowie auf Formit oder Formose gestartete Polyether (DE-OS 26 39 083 bzw. 27 37 951) kommen in Frage. Besonders bevorzugt sind solche Polyether, die überwiegend bis zu 90 Gew.-% sekundäre OH-Gruppen aufweisen.

Gegenstand der Erfindung sind auch nach den, erfindungsgemäßen Verfahren erhältliche thixotropierte Polyole. Die erfindungsgemäß erhaltenen thixotropierten Polyole, behalten ihre thixotrope Eigenschaft auch während längerer Lagerung und können so zur Thixotropierung von lagerstabilen PU-Reaktivmischungen, insbesondere von Polyurethanbeschichtungs- und/oder Klebstoffmassen verwendet werden.

Ein weiterer Gegenstand der vorliegenden Erfindung sind daher auch Verfahren zur Thixotropierung von PU-Reaktivsystemen aus Polyolen, Uretdionringe enthaltenden Polyisocyanaten mit retardierter Reaktivität, gegebenenfalls üblichen Kettenverlängerern und Hilfs-und Zusatzstoffen, die dadurch gekennzeichnet sind, daß die Polyolkomponente zu mindestens 50 % aus den erfindungsgemäß thixotropierten Polyolen besteht.

Bei Raumtemperatur lagerstabile, in der Hitze dagegen härtbare Reaktivsysteme zur Herstellung von Polyurethanen sind bekannt. Dazu werden feste Polyisocyanate mit retardierter Reaktivität in höhermolekularen, mit Isocyanatgruppen reaktiven Verbindungen, vorzugsweise höhermolekularen Polyolen und/oder Polyaminen, suspendiert (vgl. DE-OS 31 12 054, DE-OS 32 30 757).

Insbesondere werden nach der DE-OS 3 112 054 und DE-OS 3 230 757 (EP-A 103 323) durch Reaktion mit z.B. Polyaminen, Hydrazin(en) oder Hydrazidverbindungen mit -CO.NH.NH$_2$-Endgruppen stabilisierte, feste Polyisocyanate mit einer retardierten Reaktivität hergestellt. Durch die Stabilisierung mittels Polyadduktumhüllung werden Polyisocyanatteilchen erhalten, welche in den PU-Einkomponenten-Reaktivsystemen erst oberhalb einer bestimmten Temperatur, der sogenannten Aufdickungstemperatur, als freie Polyisocyanate in Reaktion treten.

Unterhalb dieser Temperatur verhalten sich die Polyisocyanat-Teilchen äußerlich inert. In Form ihrer Suspensionen in höhermolekularen Polyolen und/oder Polyaminen, gegebenenfalls unter Zusatz von niedermolekularen Polyolen oder (aromatischen) Polyaminen, stellen sie unterhalb dieser sogenannten "Aufdickungstemperatur" lagerstabile Reaktivsysteme dar. Oberhalb der Aufdickungstemperatur beginnt die Polyadditionsreaktion abzulaufen.

3

In diesen sogenannten Einkomponenten-PU-systemen sind die Reaktions-Komponenten vorzugsweise in den für die Herstellung der fertigen PU-Kunststoffe bereits richtigen Mengenverhältnis enthalten. Die ausgehärteten Polyurethane werden durch einfaches Erhitzen des Einkomponentensystems auf Temperaturen von 70-180° C, bevorzugt 100-130° C hergestellt.

Bevorzugt sind Zusammensetzungen, in denen Isocyanate und Amine bzw. Polyole in solchen Mengen enthalten sind, daß eine Kennzahl von 50 bis 200, vorzugsweise 90 bis 135, eingehalten wird.

Als feste Polyisocyanate kommen solche in Frage, die einen Schmelzpunkt über 40° C, vorzugsweise über 80° C aufweisen, z.B. 1,5-Naphthalin-diisocyanate, dimeres 4,4'-Diisocyanatodiphenylmethan, dimeres 2,4-Diisocyanatotoluol, 3,3'-Diisocyanato-4,4'-dimethyl-N,N'-diphenylharnstoff und N,N'-Bis[4(4- oder 2-isocyanatophenylmethyl)phenyl]harnstoff. Besonders bevorzugt sind dimeres 2,4-Diisocyanatotoluol und 3,3'-Diisocyanato-4,4'-dimethyl-N,N'-diphenylharnstoff.

Die Polyisocyanate werden durch Einwirkung von vorzugsweise aliphatischen Polyaminen mit Molekulargewichten von 32-399 und gegebenenfalls durch Einwirkung von aliphatischen Polyaminen mit Molekulargewichten von 400 bis 8000 "desaktiviert" (stabilisiert). Entsprechende Desaktivierungsmittel sind in den DE-OS 3 230 757 und der DE-OS 3 112 054 aufgezählt.

Als Desaktivatoren für die Isocyanatkomponente können auch offenkettige, mono- oder bicyclische Amidine bzw. Guanidine, welche keine gegenüber Isocyanaten reaktiven Wasserstoffatome aufweisen, verwendet werden. Als Beispiele für derartige Verbindungen seien genannt: Tetramethylguanidin, Pentamethylguanidin, 1,2-Dimethyltetrahydropyrimidin, 1,8-Diaza-bicyclo[5,4,0]-undec-7-en, 1,5-Diaza-bicyclo[4,3,0]-non-5-en. Weitere Beispiele für derartige Amidine sind in der DE 3 403 500 aufgeführt.

Die Desaktivierung der festen Polyisocyanate kann bei der Herstellung des Einkomponentensystems in situ erfolgen; es ist aber auch möglich, bereits in bekannter Weise desaktivierte Polyisocyanate einzusetzen.

Als NCO-reaktives Suspendiermedium für die festen, stabilisierten Polyisocyanate werden z.B. flüssige oder niedrigschmelzende (<50° C) nieder- und/oder höhermolekulare Polyole verwendet.

Als Polyole vom Molekulargewicht 62-10000 können die bereits aufgeführten verwendet werden. Vorzugsweise sind die mindestens zwei, vorzugsweise 2 bis 4, Hydroxylgruppen und in der Regel ein Molekulargewicht von 400-8000 aufweisende Polyester, Polyether, Polythioether, Polyacetale, Polycarbonate und Polyesteramide, wie sie für die Herstellung von homogenen und von zellförmigen Polyurethanen an sich bekannt sind. Beispiele hierfür sind z.B. ausführlich in der DE-OS 2 920 501, DE-OS 2 854 384 und der DE-OS 3 230 757 aufgeführt.

Auch bereits Urethan- oder Harnstoffgruppen enthaltende Polyhydroxylverbindungen sowie gegebenenfalls modifizierte, natürliche Polyole, wie Rizinusöl, Kohlenhydrate oder Stärke, sind verwendbar. Auch Anlagerungsprodukte von Alkylenoxiden an Phenol-Formaldehyd-Harze bzw. an Harnstoff-Formaldehydharze können im erfindungsgemäßen Verfahren eingesetzt werden.

Auch Hydroxylendgruppen aufweisende Polybutadiene sind erfindungsgemäß geeignet, da sie besonders elastische und hydrolysenstabile Produkte ergeben. Es können gegebenenfalls auch Polyhydroxylverbindungen eingesetzt werden, in welchen hochmolekulare Polyaddukte bzw. Polykondensate oder Polymerisate in feindisperser oder auch gelöster Form enthalten sind.

Polyaddukthaltige Polyhydroxylverbindungen werden erhalten, wenn man Polyadditionsreaktionen (z.B. Umsetzungen zwischen Polyisocyanaten und aminofunktionellen Verbindungen) bzw. Polykondensationsreaktionen (z.B. zwischen Formaldehyd und Phenolen und/oder Aminen) in situ in o.g., Hydroxylgruppen aufweisenden Verbindungen, ablaufen läßt.

Auch durch Vinylpolymerisate modifizierte Polyhydroxylverbindungen, wie sie z.B. durch Polymerisation von Styrol und Acrylnitril in Gegenwart von Polyethern oder Polycarbonatpolyolen erhalten werden, sind für das erfindungsgemäße Verfahren geeignet.

Vertreter dieser erfindungsgemäß zu verwendenden Verbindungen sind z.B. in High Polymers, Vol. XVI, "Polyurethanes, Chemistry and Technology", verfaßt von Saunders-Frisch, Interscience Publishers, New York, London, Band I, 1962, Seiten 32-42 und Seiten 44 und 54 und Band II, 1964, Seiten 5-6 und 198-199, sowie im Kunststoff-Handbuch, Band VII, Vieweg-Höchtlen, Carl-Hanser-Verlag, München, 1966, z.B. auf den Seiten 45 bis 71, und in der DE-OS 2 854 384 und 2 920 501 beschrieben.

Geeignete Polyole sind auch hydroxylgruppenhaltige Polymerisate, beispielsweise Copolymerisate aus olefinisch ungesättigten Monomeren und olefinisch ungesättigten Monomeren mit aktivem Wasserstoff. Sie werden beispielsweise in der EP-A 62 780, Seite 5 und deren Beispielen beschrieben. Sie finden vorzugsweise Anwendung für Dichtungs-, Füll-, Kleb- oder Unterbodenschutzmassen.

Selbstverständlich können Mischungen der obengenannten Verbindungen mit mindestens zwei gegenüber Isocyanaten reaktionsfähigen Wasserstoffatom, z.B. Mischungen von Polyethern und Polyestern, eingesetzt werden.

Als in den Suspensionen gegebenenfalls enthaltene Polyole kommen auch niedermolekulare Kettenverlängerer oder Vernetzer in Frage. Bei diesen Kettenverlängerern oder Vernetzern handelt es sich insbesondere um mindestens zwei funktionelle Verbindungen, welche an aliphatische und/oder cycloaliphatische Gruppen gebundene Hydroxylgruppen und Molekulargewichte zwischen 62 und 399 aufweisen. Bevorzugt sind dabei niedermolekulare Diole mit an aliphatische oder cycloaliphatische Gruppen gebundenen Hydroxylgruppen des Molekulargewichtsbereichs 108 bis 399.

Diese Verbindungen weisen in der Regel 2 bis 8, vorzugsweise 2 bis 4, besonders bevorzugt jedoch 2, Hydroxylgruppen auf. Es können selbstverständlich auch Mischungen von verschiedenen Verbindungen verwendet werden. Als Beispiele für derartige Verbindungen seien genannt: Ethylenglykol, Diethylenglykol, Triethylenglykol, Tetraethylenglykol, Trimethylenglykol, Butandiol-2,3 und/oder -1,4, Pentandiol-1,5, Hexandiol-1,6, Neopentylglykol, 1,4-Bis-hydroxyethyl-cyclohexan, 1,4-Dihydroxycyclohexan, Terephthalsäure-bis($\beta$-hydroxyethyl)ester, 1,4,3,6-Dianhydrohexite, 1,4-Monoanhydrotetrite, Propylenglykol, Dipropylenglykol, Tripropylenglykol, Tetrapropylenglykol, Bis-2-hydroxyethyl-hydrochinon, Bis-(2-hydroxyethyl)-resorcin. Als mehrwertige Verbindungen seien genannt: Trimethylolpropan, Trimethylolethan, Hexantriol-1,2,6, Glycerin, Pentaerythrit, Chinit, Mannit, Sorbit, Rizinusöl sowie Formose oder Formit.

Ferner sind geeignet tertiäraminhaltige Di- oder Polyole, z.B. N-Methyldiethanolamin, Triethanolamin oder N,N'-Bis-hydroxyethylpiperazin.

Es sind auch Diole mit zusätzen Gruppen einsetzbar, z.B. Adipinsäure-bis-(2-hydroxyethyl)-ester, Terephthalsäurebis-(2-hydroxyethyl)-ester, Diol-urethane, Diol-harnstoffe oder Polyole, welche Sulfonat- und/oder Phosphonatgruppen enthalten, z.B. 1,6-Hexamethylen-bis-(2-hydroxyethylurethan), 4,4'-Diphenylmethan-bis-(2-hydroxyethylharnstoff) oder das Addukt von Na-Bisulfit an Butandiol-1,4, bzw. dessen Alkoxylierungsprodukte. Weitere niedermolekulare Verbindungen werden ausführlich in der DE-A 2 854 384 beschrieben.

Die obengenannten Polyole können gegebenenfalls durch Vorreaktion mit einem Unterschuß Polyisocyanat modifiziert sein.

Als Polyisocyanate kommen hierfür aliphatische, cycloaliphatische, araliphatische, aromatische und/oder heterocyclische Polyisocyanate in Betracht, wie sie z.B. in der DE-OS 2 920 501 (S. 12 bis 16) aufgeführt sind.

Besonders bevorzugt werden in der Regel die technisch leicht zugänglichen Polyisocyanate, z. B. das 2,4- und 2,6-Toluylendiisocyanat sowie beliebige Gemische dieser Isomeren ("TDI"), Polyphenyl-polymethylen-polyisocyanate, wie sie durch Anilin-Formaldehyd-Kondensation und anschließende Phosgenierung hergestellt werden ("rohes MDI"), 4,4'- und/oder 2,4'-Diphenylmethan-diisocyanat, 1,6-Hexamethylendiisocyanat, 1-Isocyanato-3,3,5-trimethyl-5-isocyanatomethyl-cyclohexan, Perhydro-2,4'-und/oder -4,4'-diphenylmethan-diisocyanat.

Es ist selbstverständlich möglich, Mischungen der o.g. Polyhydroxylverbindungen und Polyaminoverbindungen einzusetzen.

Als NCO-reaktives Suspendiermedium für die festen, stabilisierten Polyisocyanate können zusätzlich auch flüssige oder niedrigschmelzende (<50° C) nieder- und/oder höhermolekulare, aromatische und/oder aliphatische Polyamine mitverwendet werden.

Bevorzugt werden höhermolekulare Polyamine. Niedermolekulare Polyamine sind als Stabilisatoren darin gegbenenfalls in untergeordneten Mengen enthalten.

Als höhermolekulare Polyaminoverbindungen mit aromatischen Aminogruppen mit einem Molekulargewichtsbereich von 400 bis 6000 werden insbesondere solche Polyaminoverbindungen eingesetzt, wie sie durch Hydrolyse von entsprechenden NCO-Prepolymeren auf der Basis von höhermolekularen Polyhydroxylverbindungen und überschüssigen aromatischen Diisocyanaten durch (vorzugsweise basische) Hydrolyse hergestellt werden können. Beispiele für dieses Verfahren werden in der DE-OS 2 948 419, DE-OS 3 039 600, DE-OS 3 112 118, der EP-A-61 627, EP-A-71 132 und EP-A-71 139 angegeben. In der erstgenannten Patentschrift werden auch weitere Verfahren des Standes der Technik zur Herstellung von aromatischen Aminoverbindungen höhermolekularer Struktur genannt. Es handelt sich bei dem Verfahren nach DE-OS 2 948 419 und den anderen zitierten Patentschriften vorzugsweise um Polyether-Polyamine, aber auch Polyester-, Polyacetal-, Polythioether- oder Polycaprolacton-Polyamine, vorzugsweise 2-oder 3-funktionelle Polyamine, welche Urethangruppen (aus der Reaktion der entsprechenden Höhermolekularen Polyhydroxylverbindungen mit den überschüssigen Polyisocyanaten) enthalten und die Aminogruppen an dem Rest des (ehemaligen) Polyisocyanats tragen. Die aromatischen, höhermolekularen Polyamine können jedoch auch nach anderen Verfahren, z.B. durch Umsetzung von NCO-Prepolymeren mit überschüssigen Mengen an Hydrazin, Aminophenylethylamin, oder anderen Diaminen entsprechend DE-AS 1 694 152 hergestellt werden; eine andere Synthesemöglichkeit beschreibt die FR-PS 1 415 317 durch Überführung der NCO-Prepolymere mit Ameisensäure in die N-Formylderivate und deren Verseifung. Auch die Umsetzung von NCO-Prepolymeren mit Sulfaminsäure gemäß DE-AS 1 155 907 führt zu höhermolekularen Polyaminen. Neben an aromatische Reste gebundene Aminogruppen (über aromatische Polyisocyanate) tragende lassen sich auch (über aliphatische Polyisocyanate) die schon zitierten an aliphatische Reste gebundene, Aminogruppen tragenden höhermolekularen Polyaminoverbindungen herstellen. Diese höhermolekularen, aliphatischen Polyamine können sowohl als Stabilisatoren für die Polyisocyanatkomponente als auch als weitere als Suspendiermedium dienende Komponente Verwendung finden.

Als Kettenverlängerer können niedermolekulare aromatische Diamine des Molekulargewichtsbereiches 108 bis 399 eingesetzt werden. Unter aromatischen Polyaminen sollen auch solche Amine verstanden werden, welche die Aminogruppe an heterocyclische Reste mit aromatischem Charakter gebunden enthalten. Als aromatische Polyamine sind z.B. geeignet: p-Phenylendiamin, 2,4-/2,6-Toluylendiamine, Diphenylmethan-4,4'- und/oder -2,4'- und/oder -2,2'-diamine, 3,3'-Dichlor-4,4'-diaminodiphenylmethan, 3-($C_1$-$C_8$)-Alkyl-4,4'-diaminodiphenylmethan, die 3,3'-Di-($C_1$-$C_4$)-4,4'-diaminodiphenylmethane sowie die 3,3',5,5'-Tetra-($C_1$-$C_4$)-alkyl-4,4'-diphenylmethane, die 4,4'-Diaminodiphenyl-sulfide, -sulfoxide oder -sulfone, Ethergruppen aufweisende Diamine gemäß DE-A 1 770 525 und 1 809 172 (US-PS 3 654 364 und 3 736 295), gegebenenfalls in 5-Stellung substituierte 3-Halogen-1,3-phenylendiamine (DE-A 2 001 772, 2 025 896 und 2 065 869), Bisanthranilsäureester (DE-A 2 040 644 und 2 160 590), 2,4-Diaminobenzoesäureester nach DE-A 2 025 900, sowie durch eine oder zwei ($C_1$-$C_4$)-Alkylgruppen substituierte Toluylendiamine. Besonders bevorzugt sind 3,5-Diethyl2,4- und/oder -2,6-diaminotoluol (besonders ihre technischen (80/20)- oder (65/35)-Isomerengemische), unsymmetrisch tetraalkylsubstituierte Diaminodiphenylmethane, z.B. 3,5-Diethyl-3'-5'-diisopropyl-4,4'-diaminodiphenylmethan und ihre Isomerengemische entsprechend DE-A 2 902 090, 4,4'-Diaminobenzanilid sowie 3,5-Diaminobenzoesäure-($C_1$-$C_4$)-alkylester, 4,4'- und/oder 2,4'-Diaminodiphenylmethan, sowie Naphthylen-1,5-diamin.

Gegebenenfalls können die üblichen Polyurethankatalysatoren, mit besonders gutem Effekt tertiäre Amine oder Metallkatalysatoren, verwendet werden.

Als gegebenenfalls enthaltene Hilfs- und Zusatzstoffe seien genannt: Farbstoffe oder Pigmente, Füllstoffe wie Silicagel, Gips, Talkum, Aktivkohle, Metallpulver, UV-Absorptionsmittel oder Stabilisatoren wie phenolische Antioxidantien, Lichtschutzmittel, Treibmittel, oberflächenaktive Zusatzstoffe wie Emulgatoren oder Schaumstabilisatoren, gegebenenfalls Zellregler, Antiblockmittel, Silikone, Flammschutzmittel, oder fungistatisch und/oder bakteriostatisch wirkende Substanzen.

Als Füllstoffe sind z.B. Fasermaterialien, d.h. alle an sich bekannten, faserförmigen Verstärkungsmaterialien einsetzbar, z.B. Glasfasern, Graphitfasern und Asbestfasern oder Fasermaterialien, die von einem organischen Polymeren stammen, z.B. von einem Polyester wie Polyethylenterephthalat, oder vorzugsweise aromatischen Polyamiden, wie dem m-Phenylen-/Isophthalsäurepolyamid, oder dem Poly-p-phenylen-terephthalamid, oder auch Polycaprolactam. Diese Fasermaterialien können auch als Matte, Band, durchgehende Fasern, Vlies, Stoff oder als Stapelfaserwirrgemisch vorliegen. Bevorzugt sind Glasfasern, die mit Schlichten ausgerüstet sind, um den Fasern eine Affinität zu Polyurethanen zu verleihen. Die einzubauende Füllstoffmenge hängt von der gewünschten Verbesserung der mechanischen Eigenschaften ab, im allgemeinen werden 5 bis 60 Gew.-% Fasermaterial angewendet.

Sollen nach dem erfindungsgemäßen Verfahren zellige Polyurethane hergestellt werden, dann werden Wasser und/oder leicht flüchtige organische Substanzen als Treibmittel mitverwendet. Als organische Treibmittel kommen z.B. Aceton, Ethylacetat, Methanol, Ethanol, halogensubstituierte Alkane wie Methylenchlorid, Chloroform, Ethylidenchlorid, Vinylidenchlorid, Monofluortrichlormethan, Chlordifluormethan, Dichlordifluormethan, ferner Butan, Hexan, Heptan oder Diethylether in Frage.

Weitere Beispiele für Treibmittel sowie Einzelheiten über die Verwendung von Treibmitteln sind im Kunststoff-Handbuch, Band VII, herausgegeben von Vieweg und Höchtlen, Carl Hanser Verlag, München 1966, z.B. auf den Seiten 108 und 109, 453 und 455 und 507 bis 510 beschrieben.

Es können auch oberflächenaktive Zusatzstoffe (Emulgatoren und Schaumstabilisatoren) mitverwendet werden. Als Emulgatoren kommen z.B. die Natriumsalze von Ricinusölsulfonaten oder auch von Fettsäuren oder Salze von Fettsäuren mit Aminen wie ölsaures Diethylamin oder stearinsaures Diethanolamin in Frage. Auch Alkali- oder Ammoniumsalze von Sulfonsäuren wie etwa von Dodecylbenzolsulfonsäure oder Dinaphthylmethandisulfonsäure oder auch von Fettsäuren wie Ricinolsäure oder von polymeren Fettsäuren können als oberflächenaktive Zusatzstoffe mitverwendet werden.

Als Schaumstabilisatoren kommen vor allem wasserlösliche Polyethersiloxane in Frage. Diese Verbindungen sind im allgemeinen so aufgebaut, daß ein Copolymerisat aus Ethylenoxid und Propylenoxid mit einem Polydimethylsiloxanrest verbunden ist. Derartige Schaumstabilisatoren sind z.B. in der US-PS 2 764 565 beschrieben.

Es können ferner auch Reaktionsverzögerer, z.B. sauer reagierende Stoffe wie Salzsäure, organische Säurehalogenide oder organische Säuren, ferner Zellregler der an sich bekannten Art wie Paraffine oder Fettalkohole oder dimethylpolysiloxane sowie Pigmente oder Farbstoffe und Flammschutzmittel der an sich bekannten Art, z.B. Trischloroethylphosphat oder Ammoniumphosphat und -polyphosphat, ferner Stabilisatoren gegen Alterungs- und Witterungseinflüsse, Weichmacher und/oder fungistatisch und bakteriostatisch wirkende Substanzen, Füllstoffe wie Bariumsulfat, Kieselgur, Ruß oder Schlämmkreide mitverwendet werden.

Weitere Beispiele von gegebenenfalls erfindungsgemäß mitzuverwendenden oberflächenaktiven Zusatzstoffen und Schaumstabilisatoren sowie Zellreglern, Reaktionsverzögerern, Stabilisatoren, flammhemmenden Substanzen, Weichmachern, Farbstoffen und Füllstoffen sowie fungistatisch und bakteriostatisch wirksamen Substanzen sowie Einzelheiten über Verwendungs- und Wirkungsweise dieser Zusatzmittel sind im Kunststoff-Handbuch, Band VI, herausgegeben von Vieweg und Höchtlen, Carl-Hanser-Verlag, München 1966, z.B. auf den Seiten 103 bis 113 und in den DE-OSen 2 854 384 und 2 920 501 beschrieben.

Je nach Zugabe des Thixotropiermittels zu den Ausgangskomponenten erhält man bei Raumtemperatur gießbare, rakelfähige oder streichbare PU-Reaktivmischungen. Diese Reaktivmischungen sind Suspensionen eines festen, durch Polyadduktumhüllung stabilisierten Polyisocyanats in einen Polyol- und gegebenenfalls Polyamin-Komponente. Die Verfestigung dieser Mischungen erfolgt durch Hitzeeinwirkung. Die Verarbeitung der erfindungsgemäß thixotropierten Systeme richtet sich nach deren Beschaffenheit. Erfindungsgemäß thixotropierte Systeme können z.B. mit der Hand oder über eine geeignete Auspreß- bzw. Fördereinrichtung, a.B. über eine Kartusche oder eine Rakel auf gewünschte Unterlagen, z.B. textile Unterlagen wie z.B. Vliese, Gewirke und Gewebe, (Spalt)leder, Matritzen (z.B. Verloursleder-Silikon-Matritzen), oder Zwischenträger (z.B. Trennpapiere) unter Bildung von Beschichtungen oder Zurichtungen, oder auf die verschiedensten technischen Artikel aus Metall, Glas, Keramik oder Kunststoff aufgebracht und gegebenenfalls nach weiteren Handhabungs- oder technischen Verarbeitungsschritten bei erhöhter Temperatur verfestigt werden. Flüssige, bei Raumtemperatur gießbare Systeme lassen sich im Gießprozeß verarbeiten.

Die Verarbeitung kann auch im Schleuderguß erfolgen; Hohlkörper können durch Einbringung der Reaktivmasse in Formen unter Verteilung an der Oberfläche durch entsprechende Rotationsbewegungen hergestellt werden.

Bei Mitverwendung von Treibmitteln können zellige Polyurethane hergestellt werden, die gegebenenfalls eine integrale Dichtestruktur aufweisen.

Auch durch Tauchverfahren können Oberflächenbeschichtungen. Abdruckformen oder Formkörper hergestellt werden.

Beispiel 1

Herstellung von vier verschieden stark thixotropierten Polyethern zum Aufzeigen des thixotropierenden Effektes der erfindungsgemäßen Polyaddukte

In 100 Gew.-Teilen eines Polyoxyalkylenetherdiols aus 80 Gew.-% Propylenoxid und 20 Gew.-% Ethylenoxid-Anteil mit einem Molekulargewicht von 4000 werden die in Tabelle 1 angegebenen mengen von vier verschiedenen (Hydroxy)Carbonsäuren in der Hitze (etwa 100°C) gelöst. Nach dem Abkühlen auf Raumtemperatur werden die angegebenen Mengen dimeres Toluylendiisocyanat (Desmodur TT® der Firma Bayer AG) suspendiert und 0,1 Teile Pb-Octoat (Octa-Soligen Pb 24® der Firma Borchers) zugesetzt und die Mischung unter Rühren 1/2 Stunde lang auf 100°C erhitzt. Man entgast durch Anlegen eines Vakuums und läßt gleichzeitig auf Raumtemperatur abkühlen. Man erhält verdickte, z.T. thixotrope Polyether.

Die Fließkurven, d.h. die Abhängigkeit der Schubspannung $\tau$ von der Schergeschwindigkeit $\psi$, werden mit einem Instron Rotationsrheometer bei Raumtemperatur kontinuierlich aufgenommen. Verwendet wird eine Kegel/Platte-Meßanordnung von 40 mm Durchmesser bei einem Kegelwinkel von 105 mrad. Durch die Verwendung der Kegel/Platte-Meßanordnung ist gewährleistet, daß bei der jeweils eingestellten Schergeschwindigkeit über den gesamten Querschnitt der zu messenden Probe dieselbe Schergeschwindigkeit herrscht. In 25 sec wurde die Schergeschwindigkeit linear auf den Maximalwert von 2,5 $s^{-1}$ gesteigert und die Schubspannung registriert. Aus den Werten von Schubspannung $\tau$ und Schergeschwindigkeit $\psi$ wurde nach $n_a = \tau/\psi$ die scheinbare Viskosität $n_a$ berechnet.

7

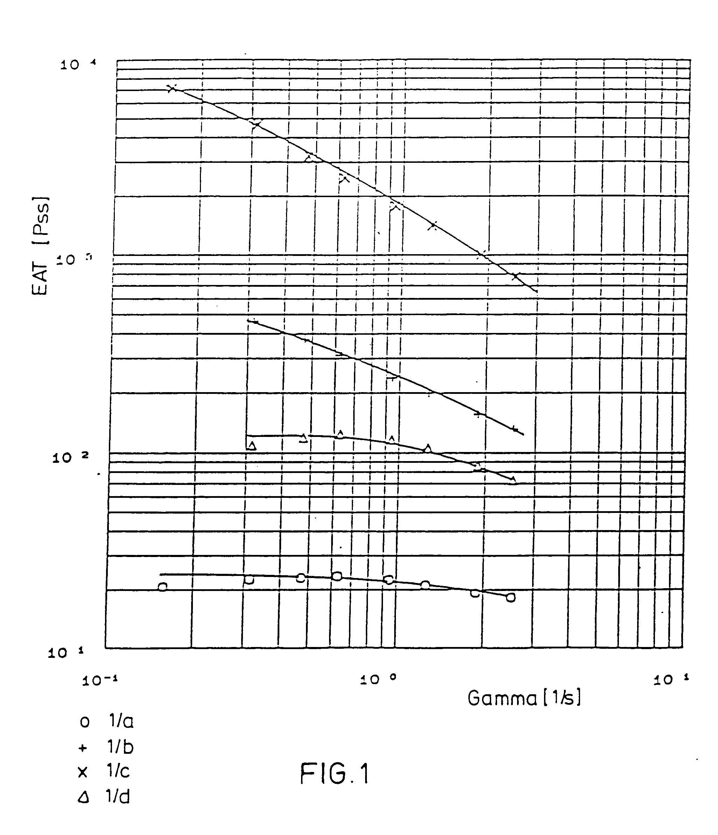

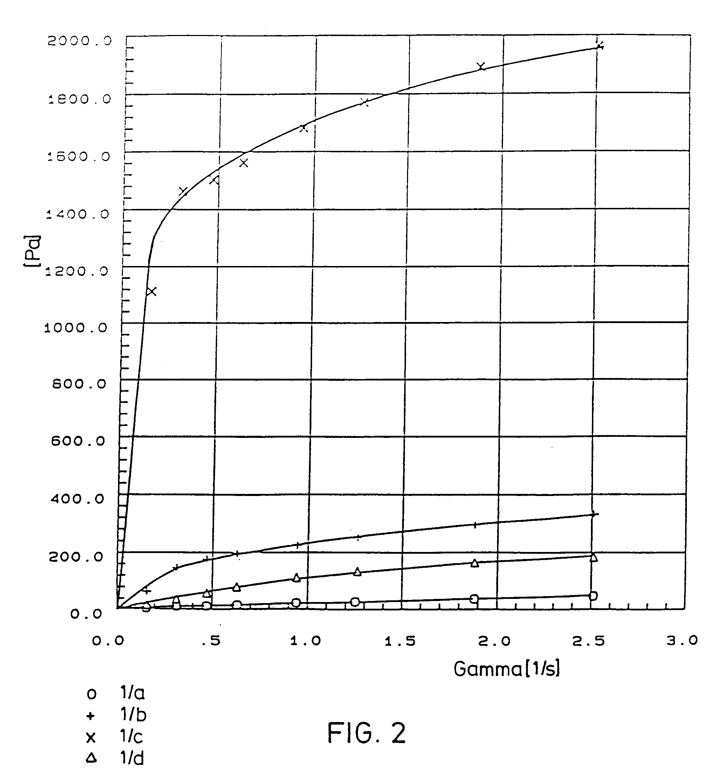

Aus den Auftragungen in Abb. 1 erkennt man den jeweiligen Grad der Thixotropie, aus den Auftragungen in Abb. 2 den jeweiligen Grad der Strukturviskosität der verdickten Polyether.

Tabelle 1:

| Beispiel | 1/a | 1/b | 1/c | 1/d |
|---|---|---|---|---|
| Gew.-Tl. Polyoxyalkylen-etherdiol, MG 4000 | 100 | 100 | 100 | 100 |
| Gew.-Tl. (Hydroxy-)Carbonsäure | 1,0 2,2-Bis(hydroxy-methyl)-propion-säure (DMPA) | 0,2 Adipin-säure | 0,1 2-Hydroxy-butandisäure (Äpfelsäure) | 0,5 Adipin-säure |
| Gew.-Tl. dimeres Toluylendiisocyanat | 3,0 | 3,0 | 3,0 | 3,0 |
| Pb-Octoat | 0,02 | 0,02 | 0,02 | 0,02 |
| Viskosität, mit Labor-Visko-Tester gemessen [Pas] | 60 | 50 | 40 | ~1000 |
| thixotroper und struktur-viskoser Charakter nach Augenschein | sehr gering | schwach | deutlich | stark |

Beispiel 2

a) Zu einer Mischung aus 67 Gew.-Teilen eines Polyoxypropylenetherdiols vom Molekulargewicht 1000 und 45 Gew.-Teile eines Polyoxypropylenethertriols mit dem Molekulargewicht 450 wird eine bei 100° C hergestellte Lösung von 0,1 Gew.-Teile Äpfelsäure in 3 Gew.-Teilen Ethylenglykol gegeben. Die Mischung wird auf 70° C erwärmt. Nun werden nacheinander 15 Gew.-Teile dimeres 2,4-Toluylendiisocyanat (Desmodur TT® der Firma Bayer AG) und 0,2 Gew.-Teile Pb-Octoat (Octa-Soligen Pb 24® der Firma Borchers) zugegeben und die Mischung 1 Stunde im Wasserstrahlvakuum auf 120° C erhitzt. Man erhält ein hochviskoses, thixotropiertes Polyol-Gemisch.

b) Unter schnellem Rühren werden in das Polyol-Gemisch nach a) nacheinander 0,7 Gew.-Teile einer 10 gew.-%igen Lösung von Diazabicyclo-2,2,2-octan (DABCO) in Polyoxypropylenethertriol mit dem MG 450 und 1,3 Gew.-Teile eines Polyoxypropylenethertriamins vom Molekulargewicht 438 (Jeffamine® T-403 der Firma Texaco) eingemischt. In die nun ein aliphatisches Amin enthaltende Mischung werden mit einem Schnellrührer 71 Gew.-Teile Desmodur TT® eingearbeitet und die Mischung 1/2 Stunde lang bei 40° C im Wasserstrahlvakuum entgast. Dabei wird die Isocyanatkomponente desaktiviert.

c) Die fertige Einkomponenten-PU-Klebstoff-Reaktivmasse bleibt nach dem Auftragen auch an senkrechten Flächen haften, ohne abzulaufen und besitzt eine Viskosität von 300 Pas und eine Aufdickungstemperatur von 90° C.

Die Klebstoffprüfung erfolgt mit 30 Gew.-% Glasfaser verstärkten Prüfkörpern aus Polyesterharz mit den Abmessungen 20 x 40 x 4 mm. Nach Auftrag des Klebstoffs in Form einer schmalen Raupe auf das Ende eines Prüfkörpers wird ein zweiter Prüfkörper auf die mit Klebstoff beschichtete Seite des ersten Prüfkörpers so aufgelegt, daß sich eine überlappte Klebfläche von 10 x 20 mm ergibt. Die zusammengefügten Prüfkörper werden mit einer Brief-Klammer zusammengehalten. Nachdem überschüssiger Klebstoff aus der Klebfuge seitlich ausgetreten ist, wird dieser abgestreift. Es ergibt sich eine Klebfilmdicke in der Klebefuge von etwa 0,2 mm. Nach 15 min Aushärtezeit bei 120°C sind die SMC-Prüfkörper fest miteinander verbunden. Die Prüfung bei Raumtemperatur ergibt eine Scherfestigkeit von 9 N/mm². Der Bruch der Klebnaht erfolgt unter Delaminierung (Kohäsionsbruch) des glasfaserverstärkten SMC-Prüfkörpers. Adhäsionsbruch (Ablösung des ausgehärteten Strukturklebstoffe ohne Zerstörung des SMC) findet nicht statt.

d) Eine Klebstoffmischung wie unter c) beschrieben jedoch ohne Äpfelsäure hergestellt besitzt keine Strukturviskosität. Sie ist fließfähig und besitzt eine Viskosität von 100 000 mPas bei Raumtemperatur, so daß sie beim Auftragen auf senkrechten Flächen Schwierigkeiten bereitet.

Beispiel 3

a) Zu 100 Gew.-Teilen eines Polyoxypropylenether-Diols vom Molekulargewicht 2000 werden unter Rühren bei Raumtemperatur 4,35 Gew.-Teile 2,4-Toluylendiisocyanat und anschließend 0,02 Gew.-Teile einer Pb-Octoat-Lösung mit 24 Gew.-% gegeben. Man erwärmt auf 100°C und rührt 1,5 Stunden bei dieser Temperatur unter einem Vakuum von 10 -20 mbar nach. Das NCO-freie (<0,05 Gew.-% NCO) OH-Prepolymer besitzt bei Raumtemperatur eine Viskosität von 4000 mPas. Sein Molekulargewicht beträgt theoretisch 4174, die OH-Zahl 26,53.

b) In 5 Gew.-Teilen des nach a) hergestellten OH-Prepolymeren werden 0,06 Gew.-Teile 2,2-Bis-(hydroxymethyl)-propionsäure (DMPA) suspendiert und durch Erwärmen auf 100°C in Lösung gebracht. Die Lösung wird 1/2 Stunde im Wasserstrahlvakuum bei 100° C entgast. Anschließend rührt man 0,5 Gew.-Teile Desmodur TT® ein und erhitzt nochmals 1/2 Stunde lang unter Rühren und Vakuum auf 100°C. Man erhält ein Polyol-Polyamin-Gemisch mit pastöser Konsistenz. Dann setzt man nacheinander weitere 85 Gew.-Teile des nach Beispiel 3a) hergestellten OH-Prepolymeren, 2,5 Gew.-Teile 2,4-/2,6-(im Verhältnis 65/35)-Diamino-3,5-diethyl-toluol und 0,25 Gew.-Teile 3,3'-Dimethyl-4,4'-diamino-dicyclohexylmethan zu, erwärmt unter Entgasen auf 100° C und kühlt anschließend auf eine Temperatur zwischen 30 und 40°C ab.

c) Mit Hilfe eines schnellaufenden Rührwerks werden 15,9 Gew.-Teile Desmodur TT® eingearbeitet. Die Abmischung kann auch in einem anderen dafür geeigneten Mischaggregat, wie z.B. einem Butterfly- oder einem Planeten-Mischer oder einem Petzholdt-Mischer erfolgen.

Durch spontane Reaktion mit dem zuvor zugesetzten Diamin auf der Oberfläche der Isocyanatteilchen wird das Isocyant unter Bildung einer Polyharnstoff-Schutzhülle desaktiviert. Nach Zusatz von 1,0 Gew.-Teilen Pb-Octoat und 1,0 Gew.-Teilen Ethylhexansäure wird 1/2 Stunde bei 40° C entgast. Man erhält ein leicht pastöses, bei Raumtemperatur und bis zu 50°C lagerstabiles, hitzehärtbares Einkomponenten-PU-Reaktivsystem.

Beim Erhitzen auf Temperaturen zwischen 100 und 120° C härtet diese rasch zu einem Elastomer der Härte 65 Shore A aus. Bei Raumtempeatur härtet dieses innerhalb etwa 7 Tagen auf 74 Shore A nach. Die Bruchdehnung beträgt etwa 200 %. Nach dem Auftragen und während des Erhitzens läuft die Reaktivmasse auf einer senkrechten Flächen nicht ab und ist daher als Beschichtungs- und Abdichtmasse gut geeignet.

d) Ein entsprechend a) - c), jedoch ohne einer Vorreaktion von DMPA mit TT hergestelltes Einkomponenten-PU-Reaktivsystem besitzt keine Strukturviskosität, ist vollkommen flüssig und besitzt bei Raumtemperatur eine Viskosität von 7000 mPas. Die mechanischen Eigenschaften des ausgehärteten PU-Reaktivsystems sind mit denen von C) identisch. Die Masse verläuft jedoch nach dem Auftragen auf feste Substrate völlig.

## Patentansprüche

1. Verfahren zur Herstellung thixotropierter höhermolekularer Polyole, mit sekundären OH-Gruppen und einem Molekulargewicht von 400 - 10000, dadurch gekennzeichnet, daß man dem Polyol 0,01 - 10 Gew.-% (bezogen auf das Polyol) einer polyfunktionellen aliphatischen $C_2$ - $C_{10}$ -Carbonsäure mit mindestens einer Carboxylgruppe und gegebenenfalls OH-Gruppen und eine mindestens äquivalente Menge (bezogen aufCarbonsäure) an Uretdionpolyisocyanaten zugesetzt und die Carbonsäure und das Isocyanat in dem Polyol umsetzt.

2. Verfahren nach Anspruch 1, dadurch gekennzeichnet, daß als höhermolekulares Polyol ein Polyetherpolyol eingesetzt wird.

3. Verfahren nach Anspruch 1, dadurch gekennzeichnet, daß als höhermolekulares Polyol ein Polyesterpolyol eingesetzt wird.

4. Verfahren nach einem der Ansprüche 1 bis 3, dadurch gekennzeichnet, daß als polyfunktionelle Carbonsäure Milchsäure, Ricinolsäure, Äpfelsäure, Weinsäure, Zitronensäure, Dimethylolpropionsäure oder Adipinsäure eingesetzt wird.

5. Thixotropierte höhermolekulare Polyole, erhältlich nach Verfahren nach einem der Ansprüche 1 bis 4.

6. Verfahren zur Thixotropierung von lagerstabilen PU-Reaktivsystemen aus Polyolen, Polyisocyanaten mit retardierter Reaktivität, gegebenenfalls üblichen Kettenverlängerern und Hilfs- und Zusatzstoffen, dadurch gekennzeichnet, daß thixotropierte Polyole nach einem der Ansprüche 1 bis 5 eingesetzt werden.

7. Verfahren nach Anspruch 6, dadurch gekennzeichnet, daß die Polyolkomponente zu mindest 50 % aus thixotropierten Polyolen nach Anspruch 5 besteht.

## Claims

1. A process for the production of thixotropicized, relatively high molecular weight polyols containing secondary OH groups and having a molecular weight of 400 to 10,000, characterized in that 0.01 to 10% by weight (based on the polyol) of a polyfunctional aliphatic $C_{2-10}$ carboxylic acid containing at least one carboxyl group and, optionally, OH groups and an at least equivalent quantity (based on carboxylic acid) of uretdione polyisocyanates are added to the polyol and the carboxylic acid and the isocyanate are reacted in the polyol.

2. A process as claimed in claim 1, characterized in that a polyether polyol is used as the relatively high molecular weight polyol.

3. A process as claimed in claim 1, characterized in that a polyester polyol is used as the relatively high molecular weight polyol.

4. A process as claimed in any of claims 1 to 3, characterized in that lactic acid, ricinoleic acid, malic acid, tartaric acid, citric acid, dimethylol propionic acid or adipic acid is used as the polyfunctional carboxylic acid.

**5.** Thixotropicized polyols of relatively high molecular weight obtainable by the process claimed in any of claims 1 to 4.

**6.** A process for thixotropicizing storable reactive PU systems of polyols, polyisocyanates of retarded reactivity, optionally typical chain-extending agents and auxiliaries and additives, characterized in that thixotropicized polyols according to any of claims 1 to 5 are used.

**7.** A process as claimed in claim 6, characterized in that at least 50% of the polyol component consists of the thixotropicized polyols claimed in claim 5.

**Revendications**

**1.** Procédé de préparation de polyols thixotropes de poids moléculaire élevé avec des radicaux OH secondaires et un poids moléculaire de 400 à 10000, caractérisé en ce que 0,01 à 10 % en poids (par rapport au polyol) d'un acide carboxylique aliphatique polyfonctionnel $C_2$-$C_{10}$ avec au moins un radical carboxyle et éventuellement des radicaux OH et une quantité au moins équivalente (par rapport à l'acide carboxylique) d'urétdionepolyisocyanates sont ajoutés au polyol et que l'acide carboxylique et l'isocyanate réagissent dans le polyol.

**2.** Procédé, selon la revendication 1, caractérisé en ce qu'un polyétherpolyol est utilisé comme polyol de poids moléculaire élevé.

**3.** Procédé, selon la revendication 1, caractérisé en ce qu'un polyesterpolyol est utilisé comme polyol de poids moléculaire élevé.

**4.** Procédé, selon une des revendications 1 à 3, caractérisé en ce que l'acide lactique, l'acide ricinoléique, l'acide malique, l'acide tartrique, l'acide citrique, l'acide diméthylolpropionique ou l'acide adipique sont utilisés comme acide carboxylique polyfonctionnel.

**5.** Polyols thixotropes de poids moléculaire élevé obtenus selon le procédé d'une des revendications 1 à 4.

**6.** Procédé pour rendre thixotropes des systèmes réactifs de polyuréthanne stables à partir de polyols, de polyisocyanates à réactivité retardée, éventuellement des agents ordinaires d'allongement de chaîne et des adjuvants ou additifs, caractérisé en ce que des polyols thixotropes sont utilisés, selon une des revendications 1 à 5.

**7.** Procédé, selon la revendication 6, caractérisé en ce que la composante polyol se compose pour au moins 50 % de polyols thixotropes selon la revendication 5.

FIG.1

FIG. 2

o   1/a
+   1/b
x   1/c
Δ   1/d